Europäisches Patentamt

(19) European Patent Office

Office européen des brevets

(11) Numéro de publication : **0 208 590**
**B1**

## (12) FASCICULE DE BREVET EUROPÉEN

(45) Date de publication du fascicule du brevet :
**13.12.89**

(21) Numéro de dépôt : **86401355.2**

(22) Date de dépôt : **20.06.86**

(51) Int. Cl.⁴ : **G 01 R 15/00**

(54) **Pince ampèremétrique à effet Hall.**

(30) Priorité : **28.06.85 FR 8509866**

(43) Date de publication de la demande :
**14.01.87 Bulletin 87/03**

(45) Mention de la délivrance du brevet :
**13.12.89 Bulletin 89/50**

(84) Etats contractants désignés :
**AT BE CH DE GB IT LI LU NL SE**

(56) Documents cités :
**DE--A-- 2 843 026**
**REVUE GENERALE L'ELECTRICITE, no. 5, mai 1984, pages 288-292, Paris, FR; G. GAUTHIER: "Le capteur d'intensité à effet Hall"**
**ELEKTROTECHNIK, vol. 62, no. 5, mars 1980, pages 74,75, Würzburg, DE; "Integrierte Halleffektschaltung"**

(73) Titulaire : **CHAUVIN-ARNOUX, Société en commandite par actions**
**190, rue Championnet**
**F-75890 Paris Cédex 18 (FR)**

(72) Inventeur : **Arnoux, Daniel**
**190 Rue Championnet**
**F-75018 Paris (FR)**
Inventeur : **Anton, Christian**
**190 Rue Championnet**
**F-75018 Paris (FR)**
Inventeur : **Genter, Claude**
**190 Rue Championnet**
**F-75018 Paris (FR)**
Inventeur : **Nascimben, Eric**
**190 Rue Championnet**
**F-75018 Paris (FR)**

(74) Mandataire : **Lefebure, Gérard et al**
**Office Blétry 2, boulevard de Strasbourg**
**F-75010 Paris (FR)**

**Description**

La présente invention concerne une pince ampèremétrique à effet Hall, comprenant un circuit magnétique composé de deux parties, qui forment une boucle pratiquement fermée et qui peuvent être écartées l'une de l'autre, un générateur de courant constant, une cellule à effet Hall placée dans un entrefer du circuit magnétique et ayant deux bornes d'entrée reliées au générateur de courant constant et deux bornes de sortie, et un amplificateur opérationnel de mesure, ayant deux entrées, respectivement inverseuse et non inverseuse, connectées respectivement aux bornes de sortie de la cellule à effet Hall par des première et seconde résistances de mêmes valeurs ohmiques.

Les pinces ampèremétriques à effet Hall sont bien connues. Le circuit électrique d'une telle pince est décrit par exemple dans DE-A-2843026. Associées à un multimètre (millivoltmètre), à un oscilloscope ou à une table traçante, elles permettent de mesurer l'intensité d'un courant continu ou alternatif et/ou d'en visualiser la forme. De telles pinces ampèremétriques sont commercialisées par exemple par la Société BELL INC. sous la désignation « CURRENT GUN » modèle CG 100 A, ou par la Société BECKMAN sous la désignation « AC/DC CURRENT CLAMP » CT 233. Ces pinces connues ont une consommation de courant relativement importante et, par suite, les piles qui servent à les alimenter en courant ont une durée de vie relativement courte. A titre indicatif, la pince ampèremétrique BELL CG 100 A est alimentée sous 6 V (4 piles de 1,5 V du type AA) et consomme environ 40 mA, soit une puissance consommée de 240 mW. La durée des piles est d'environ 30 heures avec des piles alcalines et d'environ 60 heures avec des piles au mercure (données fournies par le constructeur). La pince ampèremétrique BECKMAN CT 233 est alimentée sous 9 V (une pile de 9 V type 6 LF 22) et consomme environ 15 mA (données fournies par le constructeur), soit une puissance consommée d'environ 135 mW. Les piles de 9 V type 6 LF 22 ayant une capacité d'environ 500 mA.h, la durée de vie de la pile avec la pince BECKMAN est donc d'environ 30 heures.

La présente invention a donc pour but de fournir une pince ampèremétrique ayant une consommation de courant nettement plus faible que celle des pinces connues susmentionnées et, par suite, permettant une plus grande autonomie des piles servant à son alimentation.

A cet effet, la pince ampèremétrique de la présente invention est caractérisée en ce que le générateur de courant constant comprend un amplificateur opérationnel ayant une entrée inverseuse et une entrée non inverseuse reliées à une première borne d'alimentation qui est un premier potentiel, ledit amplificateur opérationnel comportant une référence interne de tension continue plaçant son entrée non inverseuse à un second potentiel fixe par rapport à la première borne d'alimentation, le second potentiel étant plus élevé que le premier potentiel, et un transistor NPN dont la base est reliée à la sortie dudit amplificateur opérationnel et dont l'émetteur est relié d'une part à la première borne d'alimentation à travers une troisième résistance et d'autre part directement à l'entrée inverseuse dudit amplificateur opérationnel, le collecteur du transistor NPN étant relié à l'une des deux entrées de la cellule à effet Hall, dont l'autre entrée est reliée à une seconde borne d'alimentation qui est à un troisième potentiel plus élevé que le second potentiel, et en ce que l'amplificateur opérationnel de mesure est relié, pour son alimentation en courant, à une troisième borne d'alimentation qui est à un quatrième potentiel plus élevé que le troisième potentiel, l'entrée non inverseuse et la sortie de l'amplificateur opérationnel de mesure étant reliées à la seconde borne d'alimentation respectivement par une quatrième résistance et par un premier potentiomètre, le curseur du premier potentiomètre étant relié à l'entrée inverseuse de l'amplificateur de mesure par une cinquième résistance de même valeur ohmique que la quatrième résistance, la sortie de l'amplificateur opérationnel de mesure et une borne reliée à la seconde borne d'alimentation formant la sortie de la pince ampèremétrique.

L'invention sera maintenant décrite en faisant référence aux dessins annexés sur lesquels :

La figure 1 est une vue en élévation latérale de la pince ampèremétrique de la présente invention.

Les figures 2 et 3 sont des vues respectivement de dessus et de dessous de la pince ampèremétrique de la figure 1.

La figure 4 est un schéma montrant une première forme d'exécution des circuits de la pince.

La figure 5 est un schéma montrant une deuxième forme d'exécution des circuits de la pince.

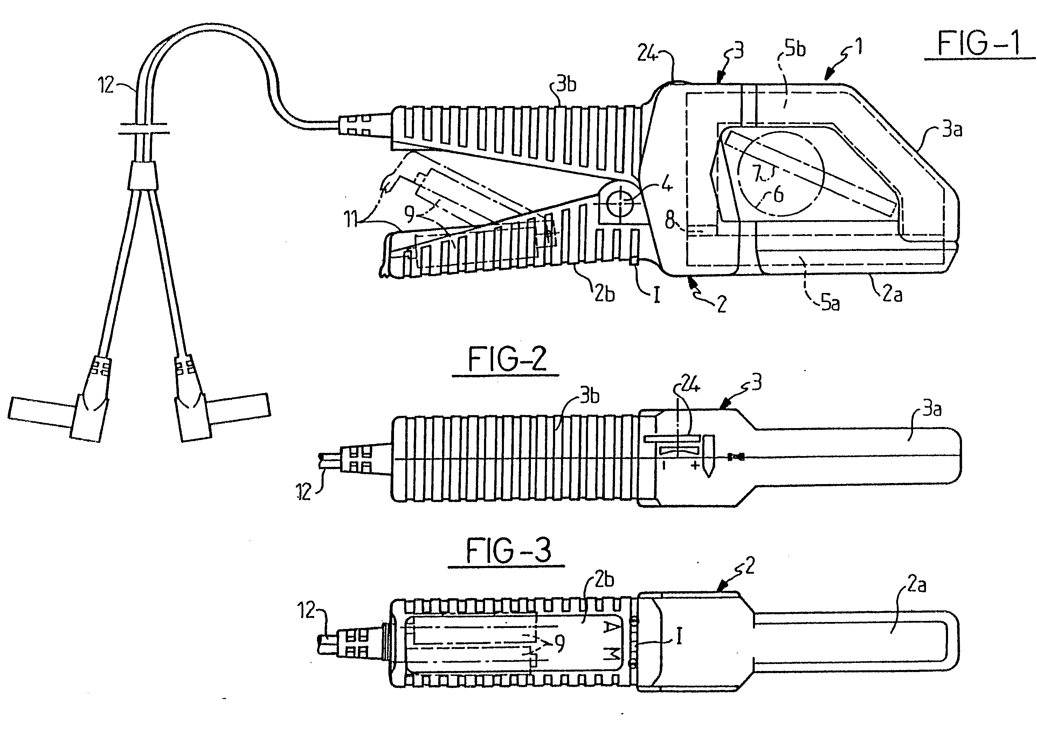

La pince ampèremétrique représentée sur les figures 1 à 3 comprend un boîtier 1 formé de deux pièces 2 et 3 en une matière isolante, par exemple en une matière plastique moulée. Les deux pièces 2 et 3 sont articulées l'une à l'autre par un axe 4 de manière à former une pince ayant deux mâchoires 2a et 3a et deux poignées 2b et 3b.

La pince 1 comprend un circuit magnétique composé de deux parties 5a et 5b qui sont respectivement logées dans les mâchoires 2a et 3a de la pince et qui forment une boucle pratiquement fermée lorsque la pince est elle-même fermée. Les mâchoires 2a et 3a de la pince et les deux parties 5a et 5b du circuit magnétique sont conformées de telle manière qu'un conducteur 6 à section circulaire ou un conducteur 7 à section rectangulaire, parcouru par un courant à mesurer, puisse être placé dans l'espace formé entre les mâchoires 2a et 3a.

Une cellule à effet Hall 8 est disposée dans un entrefer entre les deux parties 5a et 5b du circuit magnétique. La poignée 2b de la pince 1 sert de logement pour deux piles d'alimentation 9, qui sont accessibles après ouverture d'une trappe ou couvercle 11. La poignée 3b sert de logement pour une

2

plaquette de circuit imprimé (non montrée) sur laquelle sont montés les composants électriques et électroniques de la pince. Celle-ci peut être raccordée à un appareil de mesure ou d'affichage (multimètre, oscilloscope, table traçante, etc...) au moyen d'un cordon 12.

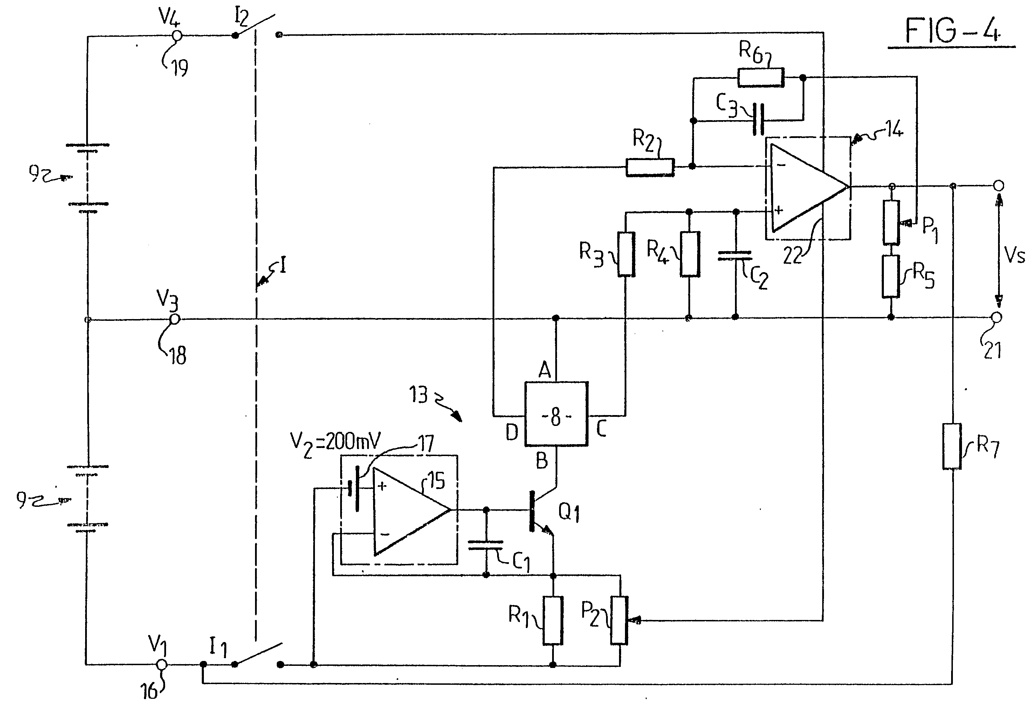

Sur la figure 4, on a représenté une première forme d'exécution des circuits électriques de la pince ampèremétrique de la présente invention, conçue pour mesurer uniquement des courants continus. Dans cette première forme d'exécution, les circuits de la pince comprennent essentiellement un générateur de courant constant 13, propre à fournir un courant constant à la cellule à effet Hall 8, et un amplificateur opérationnel de mesure 14 fonctionnant en ampli différentiel. Le générateur de courant constant 13 comprend un amplificateur opérationnel 15, dont l'entrée non inverseuse (+) est reliée à une borne d'alimentation 16 à travers un premier contact mobile I1 d'un interrupteur de marche/arrêt I (voir également les figures 1 et 3). L'amplificateur opérationnel 15 peut être par exemple constitué par une partie d'un circuit intégré du type LM10, qui comporte une référence interne de tension (représentée schématiquement sous la forme d'une pile 17) qui place l'entrée non inverseuse de l'amplificateur 15 à un potentiel positif fixe $V_2$ de 200 mV par rapport au potentiel $V_1$ de la borne d'alimentation 16. La sortie de l'amplificateur 15 est reliée d'une part à son entrée inverseuse (—) à travers un condensateur C1 et d'autre part directement à la base d'un transistor NPN Q1. L'émetteur du transistor Q1 est relié d'une part directement à l'entrée inverseuse de l'amplificateur 15 et d'autre part à la borne d'alimentation 16 à travers une résistance R1 et à travers le contact mobile I1 susmentionné. Le collecteur du transistor Q1 est relié à une entrée B de la cellule à effet Hall 8 dont l'autre entrée A est reliée à une borne d'alimentation 18 qui est à un potentiel $V_3$ plus élevé que le potentiel $V_2$ susmentionné. Par exemple, la différence de potentiel $(V_3—V_1)$ peut être fournie par une pile de 1,5 V.

Les sorties D et C de la cellule à effet Hall ε sont connectées à l'entrée inverseuse et à l'entrée non inverseuse de l'amplificateur de mesure 14 à travers des résistances R2 et R3 respectivement, de mêmes valeurs ohmiques. L'amplificateur 14 peut être constitué par une autre partie du circuit intégré susmentionné, de type LM10, dont la première partie sert à former l'amplificateur 15. L'entrée non inverseuse de l'amplificateur 14 est reliée à la borne d'alimentation 18 à travers une résistance R4. La sortie de l'amplificateur 14 est reliée à la borne 18 à travers un potentiomètre P1 et une résistance R5. Le curseur du potentiomètre P1 est relié à l'entrée inverseuse de l'amplificateur 14 à travers une résistance R6 de même valeur ohmique que la résistance R4. Des condensateurs C2 et C3 branchés en parallèle sur les résistances R4 et R6, respectivement, servent à diminuer le bruit en sortie de l'amplificateur 14. Pour son alimentation, l'amplificateur 14 est relié à travers un second contact mobile I2 de l'interrupteur de marche/arrêt I à une autre borne d'alimentation 19 qui est à un potentiel $V_4$ plus élevé que le potentiel $V_3$. La différence de potentiel $(V_4—V_3)$ peut être par exemple fournie par une seconde pile de 1,5 V. La sortie de l'amplificateur 14 et une borne 21 reliée directement à la borne 18 forment la sortie de la pince ampèremétrique, qui est reliée par le cordon d'alimentation 12 (figure 1) par exemple à un multimètre.

Un potentiomètre P2 est connecté en parallèle sur la résistance R1. Le curseur du potentiomètre P2 est connecté à une entrée 22 de l'amplificateur 14. Le potentiomètre P2 sert à régler la tension de décalage de l'amplificateur 14 (ce réglage est effectué en usine).

Le circuit décrit ci-dessus fonctionne de la manière suivante. Les contacts mobiles I1 et I2 étant fermés, l'entrée non inverseuse de l'amplificateur 15 est à un potentiel positif fixe de 200 mV par rapport à la borne 16. L'amplificateur 15 pilote le transistor Q1 qui est monté en émetteur suiveur. On asservit donc la tension aux bornes de la résistance R1 à 200 mV. Avec une résistance $R_1$ de 200 ohms, le courant qui traverse la cellule à effet Hall 8 est donc maintenu à une valeur constante de l'ordre de 1 mA, en négligeant le courant de base $I_B$ du transistor Q1, qui est environ égal à 2 μA, et le courant dérivé dans le potentiomètre P2, qui est environ égal à 20 μA si la résistance totale du potentiomètre P2 est de 10 kΩ.

Si la résistance R6 était connectée à la sortie de l'amplificateur 14 au lieu d'être connectée au curseur du potentiomètre P1, on disposerait à la sortie de la pince ampèremétrique d'une tension V (mesurée par rapport au potentiel $V_3$ servant de référence pour les mesures de tension) :

$$V = \frac{R_6}{R_2} (V_C - V_D) \tag{1}$$

$V_C$ et $V_D$ étant les tensions, mesurées par rapport au potentiel $V_3$, aux bornes de sortie C et D de la cellule à effet Hall 8, et $R_2$ et $R_6$ étant les valeurs ohmiques des résistances R2 et R6. Les valeurs ohmiques des résistances R2, R3, R4 et R6 sont choisies les plus grandes possibles, d'une part pour que l'amplificateur 14 ait un gain (R6/R2) suffisant et d'autre part pour que la sortie de la cellule à effet Hall 8 ne débite pas un courant trop important, qui entraînerait alors une non-linéarité de la réponse de la cellule.

Toutefois, pour obtenir à la sortie de l'amplificateur 14 une tension $V_s$ de 1 mV par amère continu mesuré, il faut disposer d'une marge d'amplification supplémentaire ajustable. Cette amplification supplémentaire est obtenue au moyen du point diviseur formé par le potentiomètre P1 et la résistance R5. En effet, en connectant la résistance R6 au curseur du potentiomètre P1, on obtient à la sortie de l'amplificateur 14 une tension $V_s$ telle que :

$$V_s = \frac{P_1 + R_5}{X \cdot P_1 + R_5} \cdot V \qquad (2)$$

Dans laquelle V est donné par la formule (1) indiquée plus haut, $P_1$ et $R_5$ représentent les valeurs ohmiques du potentiomètre P1 et de la résistance R5, respectivement, et X est un coefficient compris entre 0 et 1, le produit $X \cdot P_1$ représentant la valeur ohmique de la fraction du potentiomètre P1 comprise entre son curseur et sa borne connectée à la résistance R5.

A partir des formules (1) et (2) ci-dessus, on en déduit la formule (3) suivante :

$$V_s = \frac{R_6}{R_2} \cdot \left( \frac{P_1 + R_5}{X \cdot P_1 + R_5} \right) \cdot (V_C - V_D) \qquad (3)$$

La différence de tension $(V_C - V_D)$ étant proportionnelle à l'intensité du courant à mesurer, le potentiomètre P1 est réglé de telle manière que l'on obtienne à la sortie de la pince ampèremétrique une tension $V_s$ de 1 mV continu par ampère continu mesuré. Ce réglage est effectué en usine.

Une résistance R7 est branchée entre la sortie de l'amplificateur 14 et la borne d'alimentation 16. La résistance R7 a une valeur qui est choisie de telle manière que, lorsque les contacts mobiles I1 et I2 sont ouverts, on obtienne à la sortie de la pince ampèremétrique une tension ayant une valeur prédéterminée quand les piles 9 sont usées, par exemple 100 mV lorsque (V3—V1) = 1V. Ceci permet de tester la tension d'alimentation (pour indiquer par exemple s'il faut changer les piles) en connectant la pince ampèremétrique à un multimètre alors que les contacts mobiles I1 et I2 sont ouverts.

A titre indicatif, pour une pince ampèremétrique DC 10A/500A, les composants électriques et électroniques du circuit de la figure 4 peuvent être les suivants :

R1 : résistance 200 Ω
R2 : résistance 59 kΩ
R3 : résistance 59 kΩ
R4 : résistance 1 MΩ
R5 : résistance 4 kΩ
R6 : résistance 1 MΩ
R7 : résistance 136 kΩ
P1 : potentiomètre 10 tours, 10 kΩ
P2 : potentiomètre 10 tours, 10 KΩ
C1 : condensateur 1 nF
C2 : condensateur 22 pF
C3 : condensateur 22 pF
Q1 : transistor NPN BC 238 C
14 et 15 : Amplificateur linéaire LM 10
8 : cellule VHG 320 (RANK 1) de la Société Japan Victor Co.

Avec les composants indiqués ci-dessus et avec deux piles de 1,5 V connectées en série, l'une des deux piles étant connectée entre les bornes 16 et 18, l'autre pile entre les bornes 18 et 19, le courant absorbé en service par la pince ampèremétrique est de l'ordre de 1,5 mA, soit une puissance consommée de 4,5 mW. Avec deux piles alcalines de type AAA, qui ont une capacité d'environ 800 mA.h, la durée de vie des piles est d'environ 530 h. On notera que la pince ampèremétrique de la présente invention permet d'augmenter considérablement la durée de vie des piles par rapport aux pinces ampèremétriques antérieurement connues signalées plus haut, tout en permettant l'utilisation de piles de plus faibles dimensions, ce qui permet de réduire les dimensions et le poids de la pince ampèremétrique. On notera que si l'on utilisait deux piles de 1,5 V de type AA, qui ont habituellement une capacité de 1 800 mA.h, à la place de deux piles de type AAA, la durée de vie des piles serait alors d'environ 1 200 heures.

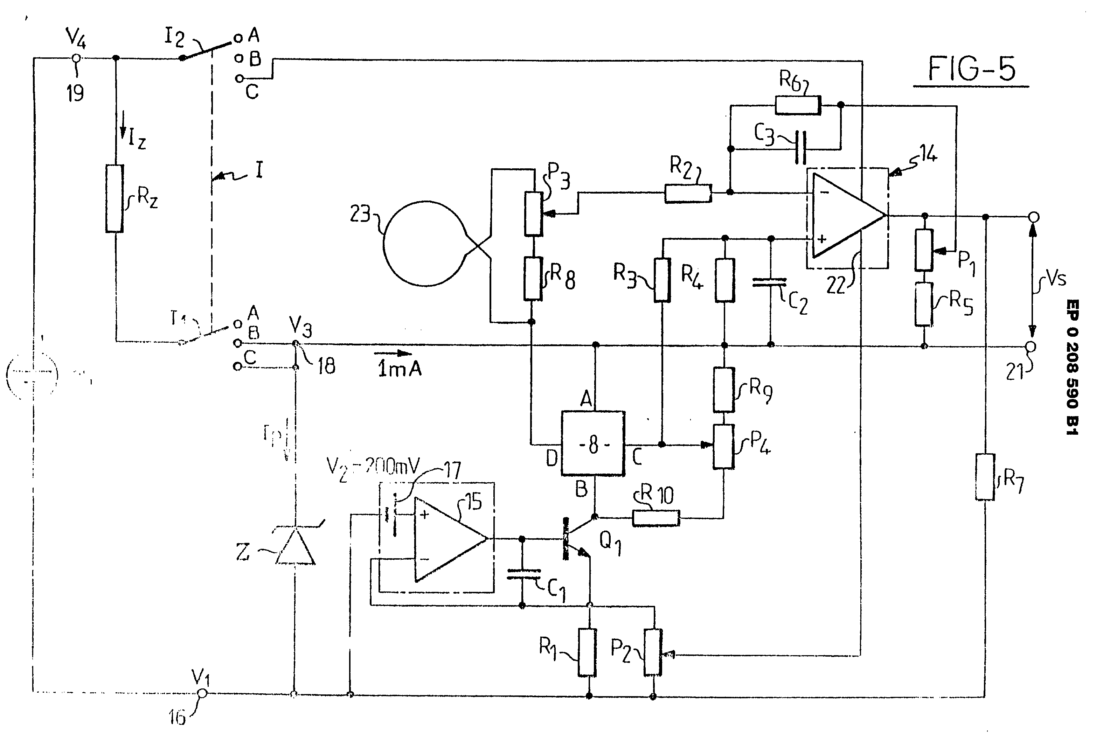

La figure 5 montre une autre forme d'exécution des circuits de la pince ampèremétrique, permettant de mesurer non seulement des courants continus, mais aussi des courants alternatifs. Un grand nombre d'éléments du circuit de la figure 5 sont identiques à ceux du circuit de la figure 4 et ne seront donc pas décrits à nouveau en détail ici. Le circuit de la figure 5 diffère de celui de la figure 4 en ce que la borne de sortie D de la cellule à effet Hall 8 est connectée d'une part à l'une des extrémités d'un potentiomètre P3 à travers une résistance R8 et d'autre part à l'une des extrémités d'une spire 23, qui entoure le noyau du circuit magnétique 5a, 5b (figure 1). L'autre extrémité de la spire 23 est connectée à l'autre extrémité du potentiomètre P3, dont le curseur est relié à l'entrée inverseuse de l'amplificateur 14 à travers la résistance R2. La spire 23 et le potentiomètre P3 forment un circuit de compensation. En effet, la spire 23 donne à ses bornes, par induction, une tension dont la valeur est fonction du courant mesuré et de la fréquence de ce courant (en continu, son influence est nulle). Par la résistance R8 et le potentiomètre P3, on somme une proportion adéquate de cette tension à la tension $(V_C - V_D)$, pour obtenir une réponse correcte en fréquence jusqu'à 500 Hz environ. Le réglage du potentiomètre P3 est effectué en usine.

La sortie C de la cellule à effet Hall 8 est connectée au curseur d'un potentiomètre P4 dont les extrémités sont reliées à la borne d'alimentation 18 et au collecteur du transistor Q1 respectivement par des résistances R9 et R10. Le potentiomètre P4 et les résistances R9 et R10 forment un circuit de réglage de zéro. En effet, après la mesure d'un fort courant continu, l'aimantation rémanente des tôles du circuit magnétique engendre une tension qu'il est nécessaire d'annuler avant de procéder à une nouvelle mesure. Ceci peut être effectué au moyen du potentiomètre P4 dont le curseur peut être manœuvré à l'aide d'une mollette 24 qui fait saillie vers l'extérieur à travers une fente prévue dans la face supérieure de la partie 3 du boîtier de la pince ampèremétrique 1 (figures 1 et 2).

A titre d'exemple, pour une pince ampèremétrique AC/DC 1A/500A, les composants du circuit de la figure 5 déjà décrits à propos de la figure 4 peuvent être identiques à ceux qui ont déjà été indiqués plus haut. Les résistances R8, R9, R10 et les potentiomètres P3 et P4 peuvent avoir les valeurs suivantes :

R8 : résistance 68 Ω
R9 : résistance 12 kΩ
R10 : résistance 12 kΩ
P3 : potentiomètre 1 tour, 470 Ω
P4 : potentiomètre 1 tour, 1 kΩ

Comme pour le circuit de la figure 4, la tension d'alimentation pour le circuit de la figure 5 peut être par exemple fournie par deux piles de 1,5 V. Cependant, la figure 5 montre une autre manière de fournir la tension d'alimentation nécessaire au fonctionnement du circuit de la figure 5 (ou de celui de la figure 4). Le circuit d'alimentation représenté dans la figure 5 comprend une source de tension continue 25, qui peut être par exemple constituée par une ou plusieurs piles, et dont la borne négative est connectée à la borne 16, tandis que sa borne positive est connectée à la borne 19. L'interrupteur bipolaire Marche/Arrêt I comporte maintenant trois positions A, B, C correspondant respectivement aux fonctions « Arrêt », « Contrôle de la tension d'alimentation », « Marche ». Une résistance Rz est connectée entre la borne positive de la source 25 et la borne 18 par l'intermédiaire du contact mobile I1 lorsque celui-ci est placé en position B. Entre la borne 18 et la borne 16 est connectée une diode zener Z. La valeur ohmique de la résistance Rz doit être choisie de telle façon que :

$$I_z = I_p + 1 \text{ mA}$$

$$R_z \cdot I_z = V_0 - V_z$$

Dans les formules ci-dessus, $I_z$ désigne le courant traversant la résistance $R_z$, $I_p$ le courant de polarisation de la diode Zener, $V_0$ la tension continue fournie par la source 25 et $V_z$ la tension Zener de la diode Zener. Pour avoir un fonctionnement correct du circuit intégré LM10 formant les amplificateurs 14 et 15, il faut que la tension $V_0$, c'est-à-dire la différence de potentiel $V_4 - V_1$, soit comprise entre 2 V et 40 V, et que la différence de potentiel $V_3 - V_1$, donc la tension Zener $V_z$, soit comprise 1 V et 20 V.

Dans le cas où la source de tension 25 est constituée par une ou plusieurs piles, le circuit d'alimentation représenté dans la figure 5 est toutefois moins avantageux que celui de la figure 4 où on utilise uniquement deux piles. En effet, il fait appel à deux composants supplémentaires (la résistance $R_z$ et la diode Zener) et il entraîne une consommation supplémentaire de courant (le courant de polarisation $I_p$ de la diode Zener).

Il va de soi que les formes d'exécution de la présente invention qui ont été décrites ci-dessus ont été données à titre d'exemple purement indicatif et nullement limitatif, et de nombreuses modifications peuvent être facilement apportées par l'homme de l'art sans pour autant sortir du cadre de la présente invention. Par exemple, bien que les figures 1 et 3 montrent les piles 9 incorporées à la pince ampèremétrique 1, la tension continue nécessaire au fonctionnement de ladite pince pourrait être fournie par une source extérieure, par exemple des piles ou des batteries incorporées au multimètre· auquel est associée la pince. Dans ce cas, le cordon 12 devra comporter, outre les deux conducteurs reliés à la sortie de la pince ampèremétrique, deux ou trois conducteurs supplémentaires fournissant les potentiels $V_1$, $V_3$ et $V_4$.

## Revendications

1. Pince ampèremétrique à effet Hall, comprenant un circuit magnétique composé de deux parties (5a et 5b), qui forment une boucle pratiquement fermée et qui peuvent être écartées l'une de l'autre, un générateur de courant constant (13), une cellule à effet Hall (8) placée dans un entrefer du circuit magnétique et ayant deux bornes d'entrée (A et B) reliées au générateur de courant constant et deux bornes de sortie (C et D), et un amplificateur opérationnel de mesure (14), ayant deux entrées, respectivement inverseuse et non inverseuse, connectées aux bornes de sortie (C et D) de la cellule à effet Hall respectivement par des première et seconde résistances (R3 et R2) de mêmes valeurs ohmiques, caractérisée en ce que le générateur de courant constant (13) comprend un amplificateur opérationnel (15) ayant une entrée inverseuse (—) et une entrée non inverseuse (+) reliée à une première borne d'alimentation (16) qui est à un premier potentiel ($V_1$), ledit amplificateur opérationnel comportant une référence interne de tension continue (17) plaçant son entrée non inverseuse à un second potentiel fixe ($V_2$) plus élevé que le premier potentiel ($V_1$), et un transistor NPN (Q1) dont la base est reliée à la sortie dudit amplificateur opérationnel (15) et dont l'émetteur est relié d'une part à la première borne d'alimentation (16) à travers une troisième résistance (R1) et d'autre part directement à l'entrée inverseuse dudit amplificateur opérationnel (15), le collecteur du transistor NPN (Q1) étant relié à l'une (B) des deux entrées de la cellule à effet Hall (8), dont l'autre entrée (A) est reliée à une seconde borne d'alimentation (18) qui est à un troisième potentiel ($V_3$) plus élevé que le second potentiel ($V_2$), et en ce que l'amplificateur opérationnel de mesure (14) est relié, pour son alimentation en courant continu, à une troisième borne d'alimentation (19), qui est à un quatrième potentiel ($V_4$) plus élevé que le troisième potentiel ($V_3$), l'entrée non inverseuse et la sortie de l'amplificateur opérationnel de mesure (14) étant reliées à la seconde borne d'alimentation (18) respectivement par une quatrième résistance (R4) et par un premier potentiomètre (P1), le curseur du premier potentiomètre étant relié à l'entrée inverseuse de l'amplificateur de mesure (14) par une cinquième résistance (R6) de même valeur ohmique que la quatrième résistance (R4), la sortie de l'amplificateur opérationnel de mesure (14) et une borne (21) reliée à la seconde borne d'alimentation (18) formant la sortie de la pince ampèremétrique.

2. Pince ampèremétrique selon la revendication 1, caractérisée en ce qu'un second potentiomètre (P2) est connecté en parallèle sur la troisième résistance (R1), le curseur du second potentiomètre (P2) étant connecté à une entrée (22) de réglage de la tension de décalage de l'amplificateur opérationnel de mesure (14).

3. Pince ampèremétrique selon la revendication 1 ou 2, caractérisée en ce qu'elle comprend un interrupteur de marche/arrêt (I) ayant deux contacts mobiles ($I_1$ et $I_2$) couplés mécaniquement et connectés en série avec les première et troisième bornes d'alimentation (16 et 19), respectivement, et en ce que la sortie de l'amplificateur opérationnel de mesure (14) est connectée par une sixième résistance (R7) à la première borne d'alimentation (16), en amont du contact mobile ($I_1$) de l'interrupteur de marche/arrêt (I), la sixième résistance (R7) ayant une valeur choisie pour que la tension de sortie de la pince ampèremétrique ait une valeur prédéterminée lorsque l'interrupteur de marche/arrêt (I) est ouvert et que des piles (9) connectées aux trois bornes d'alimentation (16, 18 et 19) sont usées.

4. Pince ampèremétrique selon l'une quelconque des revendications 1 à 3, caractérisée en ce que la borne de sortie (D) de la cellule à effet Hall (8) qui est reliée à l'entrée inverseuse de l'amplificateur opérationnel de mesure (14) est connectée d'une part à l'une des extrémités d'un troisième potentiomètre (P3) à travers une septième résistance (R8) et d'autre part à l'une des extrémités d'une spire (23) qui entoure le circuit magnétique (5a, 5b) et dont l'autre extrémité est connectée à l'autre extrémité du troisième potentiomètre (P3), le curseur du troisième potentiomètre (P3) étant relié à l'entrée inverseuse de l'amplificateur de mesure (14) à travers la première résistance (R2).

5. Pince ampèremétrique selon l'une quelconque des revendications 1 à 4, caractérisée en ce que la sortie (C) de la cellule à effet Hall qui est reliée à l'entrée non inverseuse de l'amplificateur de mesure (14), est aussi connectée au curseur d'un quatrième potentiomètre (P4) dont les extrémités sont reliées à la seconde borne d'alimentation (18) et au collecteur du transistor NPN (Q1) respectivement par des huitième et neuvième résistances (R9 et R10).

## Claims

1. A clamp-on Hall-effect probe comprising a magnetic circuit made up of two parts (5a and 5b) which form a practically closed loop and which can be separated from each other, a constant-current generator (13), a Hall-effect cell (8) located in an air gap in the magnetic circuit and fitted with two input terminals (A and B) connected to the constant-current generator and two output terminals (C and D), and an operational measuring amplifier (14) having two inputs, respectively reversing and non-reversing, connected to the output terminals (C and D) of the Hall-effect cell respectively by the first and second resistors (R3 and R2) of the same ohmic values, characterized by the fact that the constant-current generator (13) comprises an operational amplifier (15) having a reversing (—) and a non-reversing (+) input connected to a first supply terminal (16) which is at an initial potential ($V_1$), the said operational amplifier having an internal direct voltage reference (17) placing its non-reversing input at a second fixed potential ($V_2$) higher than the first potential ($V_1$), and an NPN transistor (Q1) whose base is connected to the output of the aforementioned operational amplifier (15) and whose emitter is connected firstly to the first supply terminal (16) via a third resistor (R1) and secondly directly to the reversing input of the abovementioned operational amplifier (15), the collector of the NPN transistor (Q1) being connected to one (B) of the two inputs of the Hall effect cell (8) whose other input (A) is connected to a second supply terminal (18) which is at a third potential ($V_3$) higher than the second potential ($V_2$), and by the fact that the operational measuring amplifier (14) is connected, for its direct-current supply, to a third supply terminal (19) which is at a fourth potential ($V_4$) higher than the third potential ($V_3$), the non-reversing input and the ouput of the operational measuring amplifier (14) being connected to the second supply terminal (18) respectively by a fourth resistor (R4) and by a first potentiometer (P1), the cursor of the first potentiometer being connected to the reversing input of the measuring amplifier (14) by a fifth resistor (R6) of the same ohmic value as the fourth resistor (R4), the output of the operational measuring amplifier (14) and a terminal (21) connected to the second supply terminal (18) forming the output of the clamp-on probe.

2. A clamp-on probe in accordance with Claim 1 characterized by the fact that a second potentiometer (P2) is connected in parallel to the third resistor (R1), the cursor of the second potentiometer (P2) being connected to the input (22) of the offset voltage control of the operational measuring amplifier (14).

3. A clamp-on probe in accordance with Claim 1 or 2 characterized by the fact that it is fitted with an on/off switch (I) having two mobile contacts ($I_1$ and $I_2$) which are mechanically coupled and connected in series to the first and third supply terminals (16 and 19) respectively, and by the fact that the output of the operational measuring amplifier (14) is connected by a sixth resistor (R7) to the first supply terminal (16) upstream of the mobile contact ($I_1$) of the on/off switch (I), the sixth resistor (R7) having a value selected in such a way that the output voltage of the clamp-on probe has a predetermined value when the on/off switch (I) is open and the batteries (9) connected to the three supply terminals (16, 18 and 19) are worn out.

4. A clamp-on probe in accordance with any of Claims 1 to 3 characterized by the fact that the output terminal (D) of the Hall effect cell (8) which is connected to the reversing input of the operational measuring amplifier (14) is connected firstly to one of the terminals of a third potentiometer (P3) via a seventh resistor (R8) and secondly to one of the terminals of a winding (23) which surrounds the magnetic circuit (5a, 5b) and whose other end is connected to the other terminal of the third potentiometer (P3), the cursor of the third potentiometer (P3) being connected to the reversing input of the measuring amplifier (14) via the first resistor (R2).

5. A clamp-on probe in accordance with any one of Claims 1 to 4 characterized by the fact that the output (C) of the Hall effect cell which is connected to the non-reversing input of the measuring amplifier (14) is also connected to the cursor of a fourth potentiometer (P4) whose terminals are connected to the second supply terminal (18) and to the collector of the NPN transistor (Q1) respectively by the eighth and ninth resistors (R9 and R10).

**Patentansprüche**

1. Halleffekt-Strommeßzange, die einen Magnetkreis, der aus zwei Teilen (5a und 5b) zysammengesetzt ist, ide eine praktisch geschlossene Schleife bilden und die voneinander entfernt werden können, die einen Konstantstromgenerator (13), die eine Halleffektzelle (8), die in einem Luftspalt des Magnetkreises angeordnet ist und zwei Eingangsanschlußklemmen (A und B), die mit dem Konstantstromgenerator verbunden sind, und zwei Ausgangsanschlußklemmen (C und D) aufweist, und die einen Operations-Meßverstärker (14) umfaßt, der zwei Eingänge hat, und zwar einen invertierenden und einen nichtinvertierenden, die mit den Ausgangsanschlußklemmen (C und D) der Halleffektzelle über erste bzw. zweite Widerstände (R3 und R2) mit gleichen Ohm'schen Werten verbunden sind, dadurch gekennzeichnet, daß der Konstantstromgenerator (13) einen Operationsverstärker (15) aufweist, der einen invertierenden (—) und einen nichtinvertierenden (+) Eingang besitzt, der mit einem ersten Versorgungsanschluß (16) verbunden ist, der sich auf einem ersten Potential ($V_1$) befindet, wobei der Operationsverstärker eine interne Bezugsgleichspannung (17), die seinen nichtinvertierenden Eingang auf ein zweites festes Potential ($V_2$) bringt, das höher ist als das erste Potential ($V_1$), und einen NPN-Transistor (Q1) aufweist, dessen Basis mit dem Ausgang des Operationsverstärkers (15) und dessen Emitter einerseits mit dem ersten Versorgungsanschluß (16) über einen dritten Widerstand (R1) und andererseits direkt mit dem invertierenden Eingang des Operationsverstärkers (15) verbunden ist, wobei der Kollektor des NPN-Transistors (Q1) mit einem (B) der beiden Eingänge der Halleffektzelle (8) verbunden ist, von der der andere Eingang (A) mit einem zweiten Versorgungsanschluß (18) verbunden ist, der sich auf einem dritten Potential ($V_3$) befindet, das höher ist als das zweite Potential ($V_2$), und daß der Operations-Meßverstärker (14) zur Versorgung desselben mit Gleichstrom mit einem dritten Versorgungsanschluß (19) verbunden ist, der sich auf einem vierten Potential ($V_4$) befindet, das höher ist als das dritte Potential ($V_3$), wobei der nichtinvertierende Eingang und der Ausgang des Operations-Meßverstärkers (14) mit dem zweiten Versorgungsanschluß (18) über einen vierten Widerstand (R4) bzw. ein erstes Potentiometer (P1) verbunden sind, wobei der Schleifkontakt des ersten Potentiometers mit dem invertierenden Eingang des Meßverstärkers (14) über einen fünften Widerstand (R6) mit selben Ohm'schen Wert wie der vierte Widerstand (R4) verbunden ist, wobei der Ausgang des Operations-Meßverstärkers (14) und ein Anschluß (21), der mit dem zweiten Versorgungsanschluß (18) verbunden ist, den Ausgang der Strommeßzange bilden.

2. Strommeßzange nach Anspruch 1, dadurch gekennzeichnet, daß ein zweites Potentiometer (P2) mit dem dritten Widerstand (R1) parallel geschaltet ist, wobei der Schleifkontakt des zweiten Potentiometers (P2) mit einem Eingang (22) der Regelung für die Kompensations-Spannung des Operations-Meßverstärkers (14) verbunden ist.

3. Strommeßzange nach Anspruch 1 oder 2, dadurch gekennzeichnet, daß sie einen Ein/Ausschalter

7

(I) mit zwei beweglichen Kontakten ($I_1$ und $I_2$) aufweist, die mechanisch gekoppelt und in Serie mit den ersten bzw. dritten Versorgungsanschlüssen (16 und 19) verbunden sind, und daß der Ausgang des Operations-Meßverstärkers (14) über einen sechsten Widerstand (R7) mit dem ersten Versorgungsanschluß (16) in Stromrichtung vor dem beweglichen Kontakt ($I_1$) des Ein/Ausschalters (I) verbunden ist, wobei der sechste Widerstand (R7) einen so ausgewählten Wert hat, daß die Ausgangsspannung der Strommeßzange einen vorbestimmten Wert hat, wenn der Ein/Ausschalter (I) geöffnet ist und mit den drei Versorgungsanschlüssen (16, 18 und 19) verbundene Batterien (9) verwendet werden.

4. Strommeßzange nach einem der Ansprüche 1 bis 3, dadurch gekennzeichnet, daß der Ausgangsanschluß (D) der Halleffektzelle (8), der mit dem invertierenden Eingang des Operations-Meßverstärkers (14) verbunden ist, einerseits mit einem der Enden eines dritten Potentiometers (P3) über einen siebten Widerstand (R8) und andererseits mit einem der Enden einer Windung (23) verbunden ist, die den Magnetkreis (5A, 5B) umschließt und deren anderes Ende mit dem anderen Ende des dritten Potentiometers (P3) verbunden ist, wobei der Schleifkontakt des dritten Potentiometers (P3) mit dem invertierenden Eingang des Meßverstärkers (14) über den ersten Widerstand (R2) verbunden ist.

5. Strommeßzange nach einem der Ansprüche 1 bis 4, dadurch gekennzeichnet, daß der Ausgang (C) der Halleffektzelle, der mit dem nichtinvertierenden Eingang des Meßverstärkers (14) verbunden ist, auch mit dem Schleifkontakt eines vierten Potentiometers (P4) verbunden ist, dessen Enden mit dem zweiten Versorgungsanschluß (18) und dem Kollektor des NPN-Transistors (Q1) über achte bzw. neunte Widerstände (R9 und R10) verbunden sind.

FIG-1

FIG-2

FIG-3

EP 0 208 590 B1

FIG-4.

FIG-5

$V_s$

21

$R_7$

$P_1$  $R_5$

14

22

$R_6$  $C_3$

$C_2$

$R_2$

$R_4$

$R_9$  $P_4$

$R_3$

$R$ 10

A  C

$P_3$  $R_8$

-8-

B

$Q_1$

$C_1$

23

D

1mA

15

$P_2$

$R_1$

$V_3$  18

$V_2 = 200mV$  17

Z

A
B
C

A
B
C

I

$I_2$

$I_z$  $R_z$

$V_4$  19

$V_1$  16

3